# EUROPEAN PATENT APPLICATION

(11) **EP 4 610 904 A1**
(43) Date of publication of application: **03.09.2025**
(21) Application number: 24159972.9
(22) Date of filing: 27.02.2024
(51) Int. Cl.: G06Q 10/0631, G06F 30/27, G06Q 50/06

(54) **METHOD FOR PROVIDING AN APPLICATION-BASED TOOL FOR ENERGY PRESERVATION FOR BUILDINGS**

(71) Applicant: ABB SCHWEIZ AG, 5400 Baden (CH)
(72) Inventor: GUTERMUTH, Georg, 69115 Heidelberg (DE); KARAAGAC, Abdulkadir, 68526 Ladenburg (DE); BISKOPING, Matthias, 69493 Hirschberg (DE); BAUER, Philipp, 69469 Weinheim (DE); SCHLOEDER, Matthias, 69126 Heidelberg (DE); FOKKEN, Eike, 69214 Eppelheim (DE); ALEKSY, Markus, 67065 Ludwigshafen (DE); PRIMAS, Bernhard, 68165 Mannheim (DE)
(74) Representative: Maiwald GmbH

(57) **Abstract**

The invention provides a computer-implemented method for providing an application-based tool for energy preservation for buildings, the method comprising obtaining a building characteristics data set, obtaining, for one or more rooms of the building, a respective room characteristics data set representative of the room characteristics, obtaining measurement data, determining a plurality of potential energy preservation measures associated with at least one of the one or more rooms, the determining being based on a difference between expected energy consumption associated with the room derived from reference data and an actual energy consumption associated with the room, wherein the actual energy consumption is calculated based at least in part on the measurement data set, predicting energy savings associated with each of the energy preservation measures, outputting at least some of the potential energy preservation measures and associated energy savings to a user, and receiving, via the application interface, a user selection of selected energy preservation measures to be implemented.

## Description

### FIELD OF THE INVENTION

The invention provides a computer-implemented method for providing an application-based tool for energy preservation for buildings, a system, a computer program product, and a computer-readable medium.

### BACKGROUND

Generally, there is a need to reduce energy consumption of buildings. Many preservation measures are available that could be applied towards that goal. Nonetheless, in many cases such measures are at least to some degree not realized. In some cases, even simple measures with large effects may not be implemented, while measures that are not particularly effective in a given situation might be implemented, as they are commonly perceived as generally being effective measures.

Thus, it is an objective of the present invention to provide a method that allows for leveraging potential energy preservation measures for buildings more effectively.

### SUMMARY

The objective is achieved by the present invention. The invention provides a method, system, computer program product, and computer-readable medium according to the independent claims. Preferred embodiments are laid down in the dependent claims.

The computer-implemented method for providing an application-based tool for energy preservation for buildings comprises obtaining a building characteristics data set, obtaining, for one or more, in particular all, rooms of the building, a respective room characteristics data set representative of the room characteristics, obtaining measurement data indicative of, for at least one of the one or more rooms, a state of power consumers associated with the room and/or usage of the room and/or conditions in the room and/or on an outside of the room, determining a plurality of potential energy preservation measures associated with at least one of the one or more rooms, predicting energy savings associated with each of the energy preservation measures, outputting, via an application interface, at least some of the potential energy preservation measures and associated energy savings (together with the respective potential energy preservation measures) to a user, and receiving, via the application interface, a user selection of selected energy preservation measures to be implemented.

Thus, it will be understood that suitable potential energy preservation measures can be determined in an objective and reliable way and provided in such a manner that a user will have comprehensive decision support to select effective energy preservation measures to be implemented. As such, likelihood of effective measures being implemented is increased significantly.

The present disclosure may synergistically leverage actual data associated with energy consumption (from measurements) and typical consumption data (from various sources), determine relevant comparison entities (e.g. similar buildings or rooms), propose concrete measures, predict energy savings potential, and monitor actual energy savings.

The present disclosure may be seen as providing a data analytics component to identify, rate, and track energy savings potential, i.e., an energy savings predictor, to allow for implementation of efficient measures.

In the present disclosure, the terms energy preservation measure, preservation measure, and measure will be used interchangeably unless otherwise specified.

According to the present disclosure, the building characteristics data set comprises:
building configuration data representative of building configuration, particularly comprising at least one of building size (e.g. footprint and/or height of the building), number of floors of the building, usage type of the building (e.g.,
industrial facility, office building, storage facility, store building, or mixed usage building), usage time of the building (e.g., opening hours, office hours, and/or
operating hours), number of rooms of the building, type and/or characteristics of surrounding area of the building (shadow, wind shielding, exposure), and/or
building energy characteristics data of the building, particularly comprising insulation characteristics of the building and/or of components (e.g. windows, floors, walls, and/or ceiling) of the building and/or energy class of the building and/or of components of the building.

The building characteristics data set, particularly the building configuration data and/or building energy characteristics data may thus be seen as a building-level characterization of the rooms. These characteristics may, thus, apply for all rooms in the building, i.e., may not be room specific.

According to the present disclosure, the room characteristics may comprise at least one of size (floor space and/or ceiling-height) and/or shape (e.g. room layout) of the room, room orientation relative to sun and/or wind direction, usage type of the room (e.g., office, hotel room, living room, kitchen, hallway, storage room, store, mixed usage), usage time of the room (e.g., opening hours, office hours, operating hours, meeting times, and/or occupation times), relative position of the room in the building (e.g. corner room, room having no outer walls, top floor room, ground floor room, basement room, which side of the building the room is on), power consumers associated with the room (e.g., heating, cooling, air conditioning, lighting, electrically driven blinds, digital infrastructure like displays and/or computers, or the like).

The room characteristics may thus be seen as a room-level characterization of the rooms. These characteristics may, thus, be room specific. Different rooms may, however, in some cases share the same room characteristics, e.g., adjacent rooms on the same floor and facing in the same direction, both not being corner rooms, being essentially the same in configuration, usage type, and usage time. For example, this might apply to offices or hotel rooms, which often have very uniform layout and usage.

According to the present disclosure, conditions in the room and/or on an outside of the room, particularly in an adjacent room and/or outdoors at the location of the building, may comprise room occupation, temperature, humidity, and/or air pressure.

According to the present disclosure, determining a plurality of potential energy preservation measures associated with at least one of the one or more rooms is based on a difference between:
expected energy consumption associated with the room derived from reference data, such as market benchmarks (e.g. obtained from a database), comparable rooms in the same building or other buildings (e.g. measurement data of said rooms), historical data of the same room or a comparable room in the same building (e.g. historical measurement data), consumption simulation results (e.g.
obtained by modeling energy consumption, optionally in part based on measurement data), wherein reference data is obtained taking into account at least part of the building characteristics data set and/or the room characteristics data set, and optionally at least part of the measurement data set, and
an actual energy consumption associated with the room, wherein the actual energy consumption is calculated based at least in part on the measurement data set.

Whether rooms are comparable may be determined based on a similarity between the rooms. That is, as an example, the rooms may be considered to be comparable rooms where a value for a similarity measure representative of similarity between the rooms meets certain criteria, e.g. exceeds a predetermined threshold. Similarity will be discussed in more detail below.

According to the present disclosure, the measurement data may be obtained using one or more sensors arranged in one or more rooms and/or on the outside of the building. The measurement data may be obtained continuously or at predetermined intervals, such as hourly, daily, twice a day, or the like. This may depend on the circumstances at hand, such as type of measurement and/or what parameter is being measured.

As stated above, measurement data may be indicative of a state of power consumers associated with the room, for example indicative of whether the power consumer is on or off, indicative of operation settings of a power consumer, such as power settings, and/or an operation mode, and/or indicative of whether electric blinds are open or closed. The measurement data, in this case, may be data collected from the power consumers, e.g., the power consumers may provide information that indicate the state or from which the state can be derived, and/or measured by additional measuring devices.

As stated above, measurement data may be indicative of a usage of the room, such as whether a room is used or not, type of usage of the room, occupancy of the room, or the like.

As stated above, measurement data may be indicative of a temperature, occupation, humidity, and/or air pressure in the room and/or on an outside of the room. An outside of the room may be an outside of the building or an adjacent room, for example. For determining temperature, humidity, and/or air pressure in the room, respective sensor(s) may be arranged inside the room. For determining temperature, humidity, and/or air pressure on an outside of the room, respective sensor(s) may be arranged outside of the room.

Optionally, in addition to the above, for rooms where measurement data is not available and/or for which some information on the room is missing, measurement data and/or information associated with another room and/or the building may be used to substitute the missing measurement data and/or missing room information.

In the present disclosure, an application-based tool may refer to a software tool or in other words, a tool that is implemented as a software application. The application may provide the application interface configured to output data to the user and allows for the user to interact with the application, e.g., via an input device such as a touch screen, a touch pad, a keyboard, a mouse, or the like. As an example, the software application may comprise a mobile application, i.e. an application for use on a mobile device. The application may be a web application or a (operating system) native application.

Energy preservation measures, according to the present disclosure, may comprise any measures that systematically preserve energy. Such measures may include construction measures, such as adding insulation, exchanging windows and/or doors, or the like, and/or measures associated with equipment associated with the respective room, particularly power consumers. Energy preservation measures, according to the present disclosure, may alternatively or in addition comprise measures like investigating reasons for deviations between expected and actual energy consumption are observed, e.g., where the reasons cannot be automatically identified by the application itself (or not with sufficient confidence).

Measures associated with equipment may comprise adding, removing, maintenance, servicing, and/or exchanging equipment. Alternatively or in addition, measures associated with equipment may comprise adapting operation of the equipment, particularly the power consumers, associated with the respective room. For example, power consumers may be operated with different settings or with a different usage profile. Such measures are often overlooked in spite of potentially being easy to implement.

Energy savings associated with the preservation measures can be represented in any suitable unit representative of energy consumption. They may, for example, be expressed as a cumulative value or as a statistical value, such as an average.

As will be understood from the above, a wealth of different sources pertaining to the actual case at hand and suitable references, including measurement data, are employed for determining potential energy preservation measures, such that the measures are specifically efficient for the actual case at hand. Accordingly, preservation measures that would otherwise often not be considered as they are not commonly used may now be employed if they are efficient, whereas blanket measures that are commonly used may be disregarded if they are not efficient for the case at hand. Considering the data sources claimed, it will also become apparent that the measures can be determined in a very granular manner (at room level), which makes any prediction as to the efficiency of the measure more precise than known methods. As such, likelihood of effective measures being implemented is increased significantly.

It will be understood that predicting energy savings associated with each of the energy preservation measures may be carried out at least in part prior to and/or in parallel with determining a plurality of potential energy preservation measures associated with at least one of the one or more rooms, as data used for determining potential energy preservation measures may at least in part comprise predicted energy savings. Alternatively or in addition, predicting energy savings associated with each of the energy preservation measures may be carried out only after determining a potential energy preservation measure.

The method of the present disclosure may comprise determining and outputting, for the selected energy preservation measures, actual energy saving after implementation of the respective selected energy preservation measure.

An actual energy saving may, for example, be the difference between the amount of energy used in a time interval, for example from the time of implementation of the selected energy preservation measure until the present, and an expected amount of energy and for said time interval without implementation of the selected energy preservation measure.

In other words, the method may comprise determining and outputting an actual benefit in terms of energy consumption that was achieved after the selected energy preservation measure was implemented. For example, the outputting may be done via the application interface. This may be done separately for different energy preservation measures. For example, a respective actual energy saving may be determined for each selected preservation measure. Optionally, cumulative energy savings of multiple selected preservation measures may be determined and output, for example for a predetermined period of time.

Determining and providing the actual energy saving is advantageous for verifying efficiency of the respective measure, which may be used for subsequent suggestions of preservation measures and, additionally, may also serve as a motivator for a user to select further measures.

Determining the actual energy savings may comprise making comparisons of the actual energy consumption after implementation and available reference data. Alternatively or in addition, determining the actual energy savings may comprise modelling or predicting, optionally employing Al-based techniques. As an example, in case available reference data does not allow for direct comparison, such modelling or predicting may allow for nonetheless making meaningful comparisons based on the reference data. A practical example would be where reference data, such as historical data, are available only for energy consumption at specific outside temperatures and the actual energy consumption may be obtained at an outside temperature that does not match any of said specific outside temperatures. In this case, modelling or predicting may nonetheless allow for a meaningful comparison.

The method of the present disclosure may comprise outputting together with the potential energy preservation measures and associated energy savings, an indication of a reason and/or criteria and/or a data source that underlies the determining of the respective energy preservation measure.

For example, when it is determined that there is a difference between expected and actual energy consumption, reasons for determining an energy preservation measure may comprise that an anomaly is detected in the actual energy consumption, that settings and/or consumption of consumers are unexpected based on expected usage and/or expected environmental conditions, or the like.

That is, information may be provided that indicates how the respective energy preservation measure was determined. This allows for improving overall results, as a user may be able to easily apply their knowledge on reliability, trustworthiness, or other knowledge associated with the reasons, criteria, and/or data source. Such knowledge may not have been available or taken account for determining of the preservation measure. Thus, by outputting the indication of a reason and/or criteria and/or a data source, additional information can be leveraged by allowing for the user, in making the selection, to apply any relevant knowledge. As an example, if the preservation measure was suggested based on a neighboring room, the user might know that said room had a broken window, which might not make it a suitable reference room in practice but is potentially not reflected in the data used for determining the preservation measure.

The method of the present disclosure may comprise determining an updated plurality of potential energy preservation measures associated with at least one of the one or more rooms, predicting energy savings associated with each of the updated energy preservation measures, outputting at least some of the updated potential energy preservation measures and associated energy savings to the user, and receiving a user selection of selected updated energy preservation measures to be implemented. In particular, the method may further comprise determining and outputting, for the selected updated energy preservation measures, actual energy saving after implementation of the respective selected updated energy preservation measure.

That is, the determining of potential energy preservation measures may be carried out repeatedly, i.e., the potential energy preservation measures may be updated. As some implemented preservation measures might influence energy savings associated with other potential preservation measures and/or conditions may change over time in general, this leads to higher precision than a one-time determination. A user may select an updated energy preservation measure and, similarly to the energy preservation measures described further above, the actual energy savings may also be tracked for the updated energy preservation measure.

The determining of updated potential energy preservation measures may yield additional measures compared to previous or initial measures or the energy savings potential for previously suggested measures that were not implemented may be different due to other measures that were implemented in the meantime.

According to the present disclosure, the determining of the updated plurality of potential energy preservation measures may be prompted by a user input and/or triggered automatically, for example at predetermined intervals and/or whenever the user starts the application.

That is, a user may choose e.g. via interaction with the application user interface, to view the updated plurality of potential energy preservation measures, and thereby cause determination thereof. Alternatively or in addition, the determination of the updated plurality of potential energy preservation measures may automatically take place at given times or intervals. Alternatively or in addition, the updated plurality of potential energy preservation measures may be determined automatically in response to a user starting the application. With automatic determination, it is possible to push information on potential energy preservation measures to the user, leading to a higher likelihood of selection and implementation of the measures.

According to the present disclosure, predicting energy savings associated with each of the energy preservation measures may comprise using historic data of the same room or other rooms to predict the energy savings of the respective energy preservation measure, particularly using said historic data for training a machine learning model to predict the energy savings.

That is, predicting energy savings may be at least semi-empirical. Machine learning may be useful for leveraging a diverse dataset of historical data to make accurate predictions even for rooms where a similarity to other rooms is difficult to recognize or there is not too much data for comparable/similar rooms.

Use of historic data allows for very precise predictions, particularly when concerning the same room or similar/comparable rooms. In the case of the same room, historic data may allow for recognizing patterns or developments related to energy consumption and/or room characteristics. Using data of other rooms, particularly similar rooms, allows for leveraging a larger amount of data, which improves prediction accuracy. Moreover, in case measures are implemented in other, particularly similar, rooms, historic data may also be useful for observing the effect of said measures, which may be used in addition to or alternatively to theoretical predictions. Historic data are particularly useful when using them to train a machine learning model. In this case, historic data for rooms, even rooms that are not necessarily similar to the room in question, may be used to train the model to predict energy savings for different types of rooms.

The method of the present disclosure may comprise determining which of the potential energy preservation measures are output to the user based on the difference between expected energy consumption (i.e., if the measure were implemented) and actual energy consumption, particularly selecting potential energy preservation measures for which the difference exceeds a predetermined threshold and/or is among a predetermined number N of potential energy preservation measures associated with the highest difference.

In other words, candidate preservation measures may be identified. It may be evaluated how much impact the candidate preservation measures would make. This may be done by determining a difference between expected energy consumption which would be expected if the measure is implemented and an actual energy consumption which is currently observed and/or projected for the future if the measure is not implemented. This is a robust measure and does not require much, if any, additional effort compared to the other steps of the method of the present disclosure.

A ranking of the candidate preservation measures may, for example, be obtained, and the top ranked ones may be the potential preservation measures that are output, particularly the top N measures in the ranking. Alternatively all candidate preservation measures exceeding a certain threshold may be output as potential preservation measures. Yet alternatively, approaches may be combined, e.g., only top ranked candidate measures that exceed the threshold may be output as potential preservation measures, optionally only a limited number thereof.

Such strategies have the advantage that usually there is a limitation as to how many measures can actually be implemented in practice. Accordingly, limiting the number of measures which are output, is resource preserving while not being a significant detriment, particularly as the criteria explained above ensure that the ineffective measures will rather be dropped than the more effective ones. Moreover, coming back to the discussion above, very common measures that would usually be recommended as a blanket recommendation, may make room for other measures that are more effective for the case at hand.

According to the present disclosure the determining of potential energy preservation measures based on the difference between expected energy consumption and actual energy consumption may comprise selecting a reference room by determining a room having, among a plurality of candidate reference rooms for which reference data is available, the highest similarity between the room and the reference room. The similarity between the room and the reference room may be determined based on at least part of the building characteristics data set and/or at least part of the room characteristics data set, and optionally at least part of the measurement data set. The method may further comprise using the reference data associated with the selected reference room for determining the expected energy consumption.

Using similar rooms has the advantage that reasonably accurate predictions can be made with relatively small data sets. The more similar two rooms are, the more likely it is that data observed for one of the rooms is directly transferable to the other room with reasonable certainty. If similarity is not taken into account, predictions may not be very accurate for the specific case at hand.

The factors and data used for determining similarity may be selected based on the situation at hand. Taking data from the building characteristics data set and/or room characteristics data set is, however, a good option as said data will already be available and represents characteristics that are relevant for energy consumption, which should to some extent be taken into account for similarity determination.

As an example, similarity of two rooms may be determined based on whether they are in a similar building in terms of insulation, geoposition, usage type, size, or the like. Moreover, similarity of rooms may be determined based on whether they are rooms of similar size, with a similar usage pattern, with similar locations within the building (e.g., on the same side of the building, adjacent to a same corridor, or with similar appliances), for example.

Similarity determination may take into account parameters representative of conditions. Examples of such parameters are outside temperature and/or outside light conditions and/or time of day, e.g., day or night, and/or time of year (such as season).

According to the present disclosure, the similarity may be determined by generating, for the room and the selected reference room, a respective vector representation representative of the room characteristics and optionally of the building characteristics and/or of the measurement data, and calculating a distance between the vector representative of the room and the vector representative of the respective reference room, the similarity being proportional to the distance.

In the vector, there may be a respective entry for each of multiple different characteristics and/or measurement parameters. Such a vector (with entries for the same characteristics and/or measurement parameters) may be created for each of multiple rooms.

Such a vector representation is advantageous where multiple aspects (e.g. characteristics or measurement parameters) are to be taken into account for determining similarity. The vector distance will be a suitable measure for overall similarity.

According to the present disclosure, the determining of potential energy preservation measures based on the difference between expected energy consumption and actual energy consumption may comprise determining whether the difference exceeds a threshold, particularly a threshold that indicates an anomaly in the actual energy consumption.

This may allow for identifying measures that are likely to have a large impact and potentially even identifying and remedying a problem that causes an anomaly. For example, it might be determined that an appliance or a component associated with the room is faulty where there is a particularly large difference.

The method of the present disclosure may comprise determining and outputting, together with the potential energy preservation measures, an indicator of a type or level of effort required for implementing the respective measure, such as whether implementing the measure requires adjustment of operation settings, modifying operation control programs, rearrangement or re-configuration of components in a room and/or construction measures.

Determining the required effort alongside the potential measures allows improved selection of measures, particularly where the overall effort that can be put into implementing measures is limited. For example, it will be easy to identify, for different measures, a relation between effort and the effect (energy savings) associated with the measure. It may also be possible to select multiple low-effort measures of low or medium effect, rather than a high-effort measure with high effect, in case it is determined that the overall effect for the same effort is larger when implementing the medium-effect measures. Alternatively, on an individual basis, measures may be ranked by the relation between effect and effort, and measures may be selected based on the ranking of the measures.

The method of the present disclosure may comprise obtaining pricing data comprising one or more energy prices associated with energy supplied to the building and calculating and outputting expected cost savings associated with the potential energy preservation measures based on the energy prices and the expected energy savings and optionally determining and outputting actual cost savings associated with the selected energy preservation measures after implementation.

The method of the present disclosure may also comprise a set-up procedure wherein a user, for example by interaction with the user interface provided by the application, may enter data, such as building characteristics to be included in the building characteristics data set data and room characteristics data to be included in the room characteristics data set. The set-up procedure may further comprise specifying data sources, such as available sensors that provide measurement data and/or databases to be accessed and used for determining the energy preservation measures.

A conversion from energy savings to cost savings may be advantageous for different reasons. For example, it may allow for a user to determine whether a measure will be feasible based on implementation cost and the counterweighing cost savings. Moreover, where two measures are equally good based on other criteria, cost savings may be used on top of other criteria to break the tie between said two measures. Of course, similar to the energy savings, the predicted and actual cost savings may also serve as a motivator to take a measure or further measures.

The invention also provides a system comprising a computing system configured to carry out and/or control any of the methods of the present disclosure.

The invention also provides a computer program product comprising instructions which, when the program is executed by a computer, cause the computer to carry out and/or control any of the methods of the present disclosure.

The invention also provides a computer-readable medium comprising instructions which, when executed by a computer, cause the computer to carry out and/or control any of the methods of the present disclosure.

The features and advantages outlined above in the context of the method similarly apply to the system, the computer program product, and the computer-readable medium described herein.

Further features, examples, and advantages will become apparent from the detailed description making reference to the accompanying drawings.

### BRIEF DESCRIPTION OF THE DRAWINGS

In the accompanying drawings,
- Fig. 1: illustrates a method according to the present disclosure;
- Fig. 2: illustrates a system according to the present disclosure;
- Fig. 3: illustrates an exemplary method according to the present disclosure.

### DETAILED DESCRIPTION

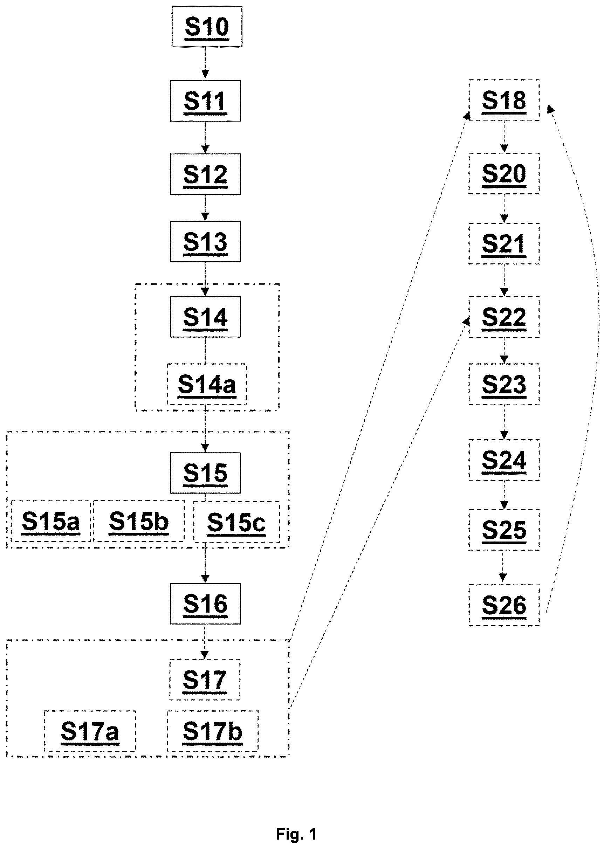

Figure 1 illustrates an exemplary method according to the present disclosure.

In step S10, the method comprises obtaining a building characteristics data set.

The building characteristics data set may comprise building configuration data representative of building configuration, particularly comprising at least one of building size, number of floors of the building, usage type of the building, usage time of the building, location of the building, number of rooms of the building, type and/or characteristics of surrounding area of the building (shadow, wind shielding, exposure). Alternatively or in addition, the building characteristics data set may comprise building energy characteristics data of the building, particularly comprising insulation characteristics of the building and/or of components of the building and/or energy class of the building and/or of components of the building.

In step S11, the method comprises obtaining, for one or more, in particular all, rooms of the building, a respective room characteristics data set representative of the room characteristics.

Room characteristics may comprise size and/or shape of the room, room orientation relative to sun and/or wind direction, usage type of the room, usage time of the room, relative position of the room in the building, and/or power consumers associated with the room.

In step S12, the method comprises obtaining measurement data indicative of, for at least one of the one or more rooms, a state of power consumers associated with the room and/or usage of the room and/or conditions (such as room occupation, temperature, humidity, and/or air pressure) in the room and/or on an outside of the room. In addition, optionally, for rooms where measurement data is not available and/or for which some information on the room is missing, measurement data and/or information associated with another room and/or the building may be used to substitute the missing measurement data and/or missing room information.

In step S13, the method comprises determining a plurality of potential energy preservation measures associated with at least one of the one or more rooms.

The determining is based on a difference between expected energy consumption associated with the room derived from reference data (such as market benchmarks, comparable rooms in the same building or other buildings, historical data of the same room or a comparable room in the same building, consumption simulation results) and an actual energy consumption associated with the room. The actual energy consumption is calculated based at least in part on the measurement data set. The reference data is obtained taking into account at least part of the building characteristics data set and/or the room characteristics data set, and optionally at least part of the measurement data set.

The determining of potential energy preservation measures based on the difference between expected energy consumption and actual energy consumption may comprise determining whether the difference exceeds a threshold, particularly a threshold that indicates an anomaly in the actual energy consumption.

The method, particularly as part of step S13, may comprise selecting a reference room by determining a room having, among a plurality of candidate reference rooms for which reference data is available, the highest similarity between the room and the reference room, wherein the similarity between the room and the reference room is determined based on at least part of the building characteristics data set and/or at least part of the room characteristics data set, and optionally at least part of the measurement data set, and using the reference data associated with the selected reference room for determining the expected energy consumption. Such a similarity may be determined by generating, for the room and the selected reference room, a respective vector representation representative of the room characteristics and optionally of the building characteristics and/or the measurement data, and calculating a distance between the vector representative of the room and the vector representative of the respective reference room, the similarity being proportional to the distance. That is, the vector distance may be a measure of the similarity.

In step S14, the method comprises predicting energy savings associated with each of the energy preservation measures. This step may, as an example, comprise using historic data of the same room or other rooms to predict the energy savings of the respective energy preservation measure, particularly using said historic data for training a machine learning model to predict the energy savings.

Step S14 may be carried out at least in part prior to and/or in parallel with step S13, as data used for determining potential energy preservation measures may at least in part comprise predicted energy savings. Alternatively or in addition, step S14 may be carried out only after determining a potential energy preservation measure.

In optional step S14a, the method comprises, prior to outputting, determining which of the potential energy preservation measures are output to the user based on the difference between expected energy consumption and actual energy consumption. For example, potential energy preservation measures for which the difference exceeds a predetermined threshold and/or is among a predetermined number N of potential energy preservation measures associated with the highest difference may be selected for outputting.

In step S15, the method comprises outputting, via an application interface, at least some of the potential energy preservation measures and associated energy savings (together with the respective potential energy preservation measures) to a user.

Optionally, expected cost savings resulting from the actual energy savings may be determined (cf. steps S22 and S23) and output (cf. step S24) alongside the energy preservation measure.

In optional step S15a, the method comprises outputting together with the potential energy preservation measures and associated energy savings, an indication of a reason and/or criteria and/or a data source that underlies the determining of the respective energy preservation measure.

In optional step S15b, the method comprises determining and, in optional step S15c, outputting, together with the potential energy preservation measures, an indicator of a type or level of effort required for implementing the respective measure, such as whether implementing the measure requires adjustment of operation settings, modifying operation control programs, rearrangement or re-configuration of components in a room and/or construction measures.

In step S16, the method comprises receiving, via the application interface, a user selection of selected energy preservation measures to be implemented. The method may infer the selection as the time at which the energy preservation measure is implemented or the user may enter a time when the energy preservation measure is expected to be implemented and/or the user may select to confirm time of actual implementation at a later time.

In optional step S17, the method comprises determining, in step S17a, and outputting, in step S17b, for the selected energy preservation measures, actual energy savings after implementation of the respective selected energy preservation measure. Optionally, actual cost savings resulting from the actual energy savings may be determined (cf. step S25) and output (cf. step S26) alongside the energy preservation measure.

In optional step S18, the method comprises determining an updated plurality of potential energy preservation measures associated with at least one of the one or more rooms. In optional step S19, the method comprises predicting energy savings associated with each of the updated energy preservation measures. In optional step S20, the method comprises outputting at least some of the updated potential energy preservation measures and associated energy savings to the user. In optional step S21, the method comprises receiving a user selection of selected updated energy preservation measures to be implemented. The method may further comprise determining and outputting, for the selected updated energy preservation measures, actual energy saving after implementation of the respective selected updated energy preservation measure. The determining of the updated plurality of potential energy preservation measures may be prompted by a user input and/or is triggered automatically, for example at predetermined intervals or whenever the user starts the application.

In optional step S22, the method comprises obtaining pricing data comprising one or more energy prices associated with energy supplied to the building and calculating, in optional step S23 and outputting, in optional step S24, expected cost savings associated with the potential energy preservation measures based on the energy prices and the expected energy savings and optionally determining, in step S25, and outputting, in step S26, actual cost savings associated with the selected energy preservation measures after implementation.

The determining of updated plurality of potential energy preservation measures S18 and subsequent steps may be carried our repeatedly, for example at intervals, such as once per week, once per month, or the like.

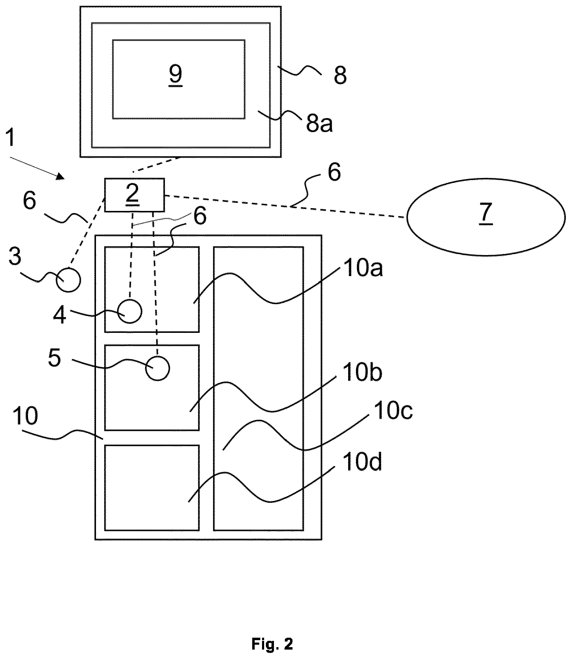

Figure 2 illustrates a system 1 according to the present disclosure. In particular, the system may be configured to carry out the method of the present disclosure, such as described in the context of Figure 1, for example.

The system comprises a data processing system 2, one or more measuring devices 3, 4, 5, and optional data connections 6 for transmitting data, e.g. wireless or wired data connections.

For illustrative purposes, a database 7, not necessarily part of the system 1, is shown connected with the processing system 2 by a data connection. The database may provide data for use in determining measures for energy saving.

Moreover, a user device 8 is shown. The user device has a display 8a on which a user interface 9 of an application is shown, the user interface allowing for the user to view and select measures and view the savings. The processing system may be part of the user device or communicatively connected to the user device. The latter scenario is shown in Figure 2 as an example. The user device is not necessarily part of the system, but may optionally be a part thereof.

For illustrative purposes, a building 10 with rooms 10a, 10b, 10c, and 10d is shown, the building not part of the system. The system can be employed by providing the building with the measuring devices and the processing system 2 processing data associated with the system.

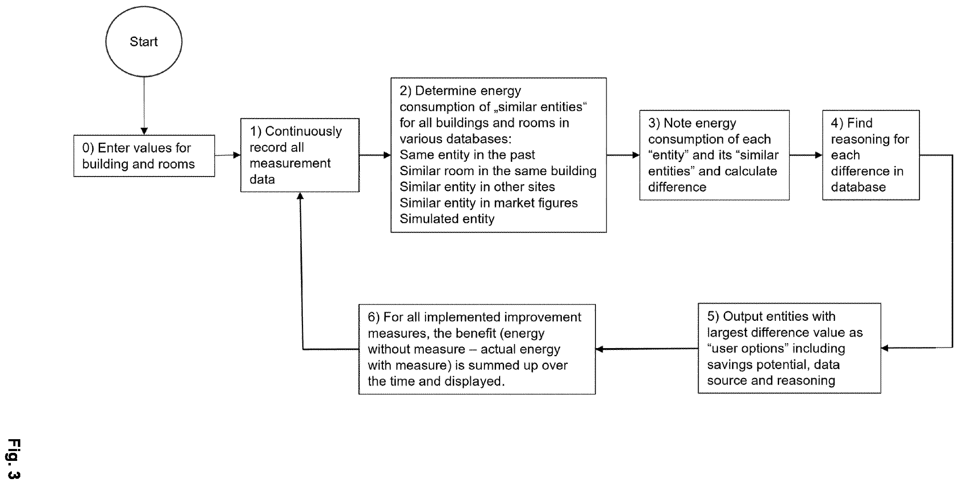

Figure 3 illustrates a flowchart of an exemplary method according to the present disclosure.

As a setup step, values are entered, e.g. by a user and/or retrieved from storage. Details on a potential set up and data entry step are also given further below.

Then, an optionally iterative, flow may start with step 1) of, e.g. continuously, recording measurement data. Details on potential measurements are given further below.

Subsequently, in step 2), energy consumption of similar entities is determined for rooms and buildings, e.g. retrieved from one or more databases. This may, for example, pertain to consumption of the same entity in the past (historic data), a similar room in the same building, a similar entity in other sites, a similar entity in market figures, a similar entity.

In subsequent step 3), energy consumption of each entity and its similar entities may be noted, and a difference may be determined.

Subsequently, in step 4), a reason for the difference may be determined.

In subsequent step 5), entities with a difference value meeting certain criteria, e.g., ones with the largest difference value, may be output as user options (also referred to as measures herein) with their savings potential, data source and reasoning.

In step 6), for all implemented improvement measures the benefit (energy without measure - actual energy with measure) is summed up over the time and displayed.

Step 6) may consist of two parts: (a) The user gets the option to mark one measure (entity) as "implemented", notifying the system of a change made in real life. (b) For all implemented measures (entities) the current consumption is noted and compared to the past consumption before the change. The difference values (net savings) are then added up over time and displayed.

Further optional features of the present method may include representing an entity (building or room) mathematically as a multi-dimensional vector, according to all its parameters. Thus, similarity between entities can be determined by distance between two vectors.

As another example, a machine learning model may be trained with entity parameters (input) and energy consumption (output) pairs. As a consequence, the ML-model can, based on new entity parameters, calculate an expectation value for the energy consumption.

The database(s) of step 4) may be used to derive a specific action from a determined anomaly (difference). The database(s) can be an online resource. As an example, multiple or all instances of the application may have access and optionally provide data to the database. Thus, the database(s) may grow over time by learnings from the past, provided by experts and/or carried out automatically when users enter the measure they have made.

The results will get better over time, with growing amount of data available and thus more data sets to compare to. However, even with typical market figures and/or similar rooms in one building, outliers can already be detected with very short time of operation in one specific building or site.

Further examples and features of the present disclosure will be described below.

Generally, energy users, such as building owner, tenants, energy manager, facility manager, would like to save energy to reduce their energy bill and the CO₂ footprint of their building. Often, even though several and/or simple measures are available that could be applied to reach that goal. Nonetheless, the user may not take any action for various reasons: missing information, doubt about benefit, no tracking of realized measures. Specifically, reasons may include that the user does not know the available options and/or how useful the options are (energy, cost, CO₂ reduction), does not have the know-how to recognize a possible option, e.g. because it requires changing the programming of the heating or the blinds automation, or receives no feedback on the result once the measure was implemented.

All of those are factors inhibit implementation of even potentially simple solutions that could have a large effect, e.g. when several of potentially small decisions are taken, and/or bring benefit over a long time.

The present disclosure overcomes these and other challenges.

In the system and method of the present disclosure, data analytics methods may be applied to identify promising energy savings options including quantification. This may leverage current measurements and consumption values of similar entities under similar conditions.

The present disclosure may leverage data analytics to compare current consumption values and patterns with several sources, for example, average market numbers (e.g. how much electricity a family with 4 people consumes in one year), other rooms (e.g., compare all rooms in one building among each other to find outliers or anomalies), historic data (e.g., compare the current consumption in buildings or part of it with past data of the same location), comparable sites (e.g., with a larger user-base the method/system can compare a given room or site to comparable ones using the same technology), simulation results (e.g., a site energetic model of the site may enable to simulate energy consumption based on current circumstances like weather; those values can as well be taken as data to compare actual measurement values to).

As one benefit, the present disclosure introduces a system and method that enables a very informed user selection concerning all those aspects. The method of the present disclosure may also offer a highly increased user acceptance when it comes to implementing energy savings methods due to the quantitative and tailored determination provided and the application-based approach allowing for efficient interaction, and particularly by making saving energy intuitive and potentially fun, e.g. by gamification, and measurable. This may be enhanced by usability features such as offering very specific (from low profile to investment) options to save energy, giving concrete savings numbers (CO₂, cost, energy) so that the user can decide if this measure is worth the drawbacks e.g. effort, investment or loss of comfort, giving the reasoning for each of the measure in the sense that the user can judge if this measure bases on real facts or might be the result of a one-time event, once a measure is implemented, a tool for tracking the real savings which will motivate even further. An application may allow for gamification of the user interaction, e.g., to motivate the user to take certain steps.

In an example, the present disclosure may provide a method with the following interaction points between an application and the user:
(1) Data entry /setup of the home or site topology, such as assets and sensors, as well as some general information, such as contracts and location. This may be required only once.
(2) Determine and present energy saving choices: a number of concrete energy savings options including drawbacks, savings potential and the reasoning (source) where the underlying data comes from is listed. This can be done on demand. The user can select some of them and implement them in real life.
(3) Energy reporting: Showing the achieved savings over time to the user, e.g. on demand.

Examples for each of those steps are described in detail below:

### (1) Data entry /setup

As a first step basic information of the building may be input into the application.

The data may, for example, be aggregated into a data set.

The data set may comprise a first data set, e.g. a general information data set, which may comprise building characteristics data set. The first data set may comprise one or more of: an identification of the building in question, physical information on the building, such as square meter footprint, number of floors, geo position, size, energy class information for components of the building, such as insulation, windows, electrical appliances, heating. The first data set, alternatively or in addition, may comprise measurement data, such as outside temperature or solar radiation, a usage time (detected or entered), contractual information, such as electricity price, gas price, or the like.

An exemplary table for a first data set, e.g., a general information data set, is inserted below.

| Building | Basics | Size [m²] | Measurements | Usage time | Energy class | Contracts |
|---|---|---|---|---|---|---|
| Hotel 1 | 4 floors | 750 | Outside Temp. | Main usage | Insulation: B (built 1998) | EL energy: 0,35 €/kWh |
| | 600 m² footprint | | Solar radiation | 7:30 - 21:00 | Windows: B (two sectors) | EL power: 0.3 €/kW |
| | geoposition X, Y | | | | Electrical: A (new appliances) | Gas: 0.15 €/kWh |
| | | | | | Heating: C (gas) | |

Additionally, the data set may comprise a second data set, e.g. a room-level information data set, which provides details of the individual rooms and data representing how the sensor and measurement data are connected with the respective rooms.

For example, the second (room-level information) data set may, for a respective room, comprise a room ID, room size, a usage profile, such as office, meeting room, walking area, guest room, stairway, potentially with added details, e.g., how many people the room fits or typical usage times. The room-level information data set may also comprise information on available measurement data or sensors, such as data related with the state of blinds, the temperature, the CO₂ level, the heater, AC, HVAC, occupancy, lights, other consumers (e.g. aquarium, entertainment systems, computing systems or the like).

An exemplary table for a second (room-level information) data set is inserted below.

| **Room ID** | **Usage profile** | **Size [m2]** | **Measurements** |
|---|---|---|---|
| Office 1 | Office (2 people 9:00-18:00) | 25 | Blinds (signal-11) |
| | | | Temperature (signal-21) |
| | | | CO2 sensor (signal-01) |
| | | | Heater (signal-31) |
| Conference 1 | Meeting room (up to 6 people) | 40 | Blinds (signal-13) |
| | | | Temperature (signal-24) |
| | | | Heater (signal-33) |
| | | | Occupancy (singal-51) |
| Lobby | Walking area (24 hours) | 200 | Blinds (sig.-14) |
| | | | Temperature (sig.-25) |
| | | | HVAC (signal-41) |
| | | | Lights (signal-61) |
| | | | Aquarium (signal-71) |
| Twin room 1 | Guest room (1-3 people) | 45 | CO2 sensor (signal-02) |
| | | | Temperature (signal-22) |
| | | | HVAC (signal-42) |
| Conference 2 | Meeting room (up to 20 people) | 65 | Blinds (signal-12) |
| | | | Temperature (signal-23) |
| | | | Heater (signal-32) |
| Stairway 1 | Stairway | - | Occupancy (singal-52) |
| | | | Lights (signal-62) |

### (2) Step 2 involves providing energy savings choices.

As an example, an energy savings options data set may be rendered to be presented to a user, e.g. in the form of a table, an example of which is shown below.

| | | | **Savings** | | | |
|---|---|---|---|---|---|---|
| **ID** | **Measure** | **Effect** | **€/d** | kg_{CO2}/d | **Source** | **Selection** |
| 1 | Reduce heating "Office 1" by 1°C | Savings of 12 kWh_{gas} / day | 6 | 150 | Verified from historic data | Implemented |
| 2 | Close the door/windows of "Conference 1" while heating | Savings of 15 kWh_{gas} / day | 7.5 | 180 | Anomaly detected | |
| 3 | Close blinds of "Lobby" when sunny | Savings of 18 kWhₑₗ / day | 7.2 | 58 | Verified from historic data | Don't propose again |
| 4 | Install occupation sensor for light in "Conference 2" | Savings of 1 kWhₑₗ / day | 0.5 | 5 | Anomaly detected | |
| 5 | Consider improving insulation of "Conference 2" | Savings of 25 kWh_{gas} / day | 13 | 300 | Comparison with comparable rooms | |
| 6 | Consider tuning the heating system for "Hotel 1" | Savings of 120 kWh_{gas} / winter day | 60 | 1500 | Anomaly to other houses | To be implemented |

As an example, the energy saving options data set may comprise several measures and optionally IDs associated with the measures and their expected associated saving effect, e.g. expressed in at least one of reduction of energy usage, reduction of costs, reduction of CO₂. Optionally, the data set may also comprise data indicative of the source used for identifying the measure and/or its effect, e.g., based on historic data, comparison with similar rooms or comparison with other buildings. The source may, particularly, be a detected anomaly. The energy saving option data set may also comprise, for the respective measure, a user selected status, such as "implemented", "to be implemented", or "do not propose again".

The selection may, for example, be made by the user via the application, e.g. by interacting with the rendered energy savings options data.

Thus, the user can select from a list of options, the measures they would like to implement, and can confirm, once the measure was implemented (in some cases, e.g. cases of 4-6 this might take some time).

The exemplary measures shown above in the table will be explained in more detail in the following:
- Measure 1: The system recorded historic gas consumption, depending on weather (sig.-91) and heating setting (sig.-31) in "Office 1". Knowing the current outside temperature and the "usual" heater setting, it can calculate the average gas saving that a reduction of 1°C will bring. (historic data)
- Measure 2: Looking at the gas consumption pattern of "Conference 1" the system can identify an anomaly that once a day the consumption increases (or temperature drop) without an apparent reason. So, the assumption is that in those times the door or windows are open without turning down the heating. Thus, the system proposes the measure and can compare current consumption with the hypothetical one without the outliers. (anomaly in historic data)
- Measure 3: The system realizes that not always when the sun is shining into the "Lobby" (sig.-92), the blinds are being closed (signal-14), leading to an increase in temperature (sig.-25) and the need of HVAC (signal-41). By comparison with times when the blinds have been closed a savings potential can be calculated.
- Measure 4: The system realizes that comparing the light usage of "Conference 2" with "Conference 1" the times when the lights are on are much longer, even sometimes exceeding the "main usage hours". This is a hint that lights have been left on, as "Conference 2" does not have an occupancy sensor, as "Conference 1" does. Reducing the most obvious outliers in the past give the savings potential.
- Measure 5: Comparing "Conference 2" with rooms in the database, concerning:
   usage-type, size, geography, insulation, windows and heating class might show that the room is consuming a lot above average. Another option would be to simulate temperature drop after turning down the heating and compare with the real behavior. A large deviation is an indication of some insulation problem. Comparison of "as is" to the comparison gives a possible savings value.
- Measure 6: Comparing the overall heating system of "Hotel 1" to similar ones (concerning type, geography and building size) it can be detected that the behavior deviates from the average one. In the example we assume that when temperature drops below 0°C, the increase in gas consumption is more than in other buildings. This can be an indication for a not well tuned heating system. The potential saving can be estimated by taking an average value of comparable buildings.
- Measure 7 (not shown): By comparing all "guest rooms" in the same building to one another, one could identify outlier rooms that might need further inspection. The potential saving can be estimated by reducing the consumption of the outlier room to an average consumption.

### (3) Benefit reporting

Benefit reporting may comprise generating and rendering a representation of a benefit reporting data set. Such a data set may comprise, for a respective measure, the date on which its implementation was selected and/or the date on which the measure was actually implemented, the savings, for example saved energy and optionally saved costs, and further optionally the measure ID. Further, optionally a comment may be provided, such as whether the measure was fully or only partially followed through or whether the measure met, exceeded, or did not meet the expectations in terms of savings. The savings may, for example, be shown as cumulative savings.

Any non-implemented /non-selected measures from the energy saving options data may be omitted from this data set, whereas all implemented measures may be included, for example.

A representation of an exemplary benefit reporting data set is shown below. In this data set, the user selected on 30.1.24 to implement measure 1 and 6, in this case, merely as an example, while deciding not to follow up on measure 3 (see status column). It can be seen from the table that measure 1 was immediately implemented after selection, e.g. by improving heating control, whereas measure 6 was implemented with some delay, e.g. because it required more time to complete implementation.

| **ID** | **Selected measure** | **Implement. Date** | **Savings** | **Comment** |
|---|---|---|---|---|
| 1 | Heating "office 1" reduced | 30.1.24 | 128 € | The measure was only considered 56% of the time |
| 6 | Heating system of "Hotel 1" tuned | 15.2.24 | 875 € | The measure exceeded expectations |

While the invention has been illustrated and described in detail in the drawings and foregoing description, such illustration and description are to be considered exemplary and not restrictive. The invention is not limited to the disclosed embodiments. In view of the foregoing description and drawings it will be evident to a person skilled in the art that various modifications may be made within the scope of the invention, as defined by the claims.

## Claims

1. A computer-implemented method for providing an application-based tool for energy preservation for buildings, the method comprising:
obtaining (S10) a building characteristics data set, wherein the building characteristics data set comprises:
building configuration data representative of building configuration, particularly comprising at least one of building size, number of floors of the building, usage type of the building, usage time of the building, number of rooms of the building, type and/or characteristics of surrounding area of the building, and/or
building energy characteristics data of the building, particularly comprising insulation characteristics of the building and/or of components of the building and/or energy class of the building and/or of components of the building;
obtaining (S11), for one or more, in particular all, rooms of the building, a respective room characteristics data set representative of the room characteristics, wherein
particularly the room characteristics comprise at least one of size and/or shape of the room, room orientation relative to sun and/or wind direction, usage type of the room,
usage time of the room, relative position of the room in the building, power consumers associated with the room;
obtaining (S12) measurement data indicative of, for at least one of the one or more rooms, a state of power consumers associated with the room and/or usage of the room and/or conditions, such as room occupation, temperature, humidity, and/or air pressure, in the room and/or on an outside of the room, particularly in an adjacent room and/or outdoors at the location of the building;
determining (S13) a plurality of potential energy preservation measures associated with at least one of the one or more rooms, the determining being based on a difference between
expected energy consumption associated with the room derived from reference data, such as market benchmarks, comparable rooms in the same building or other buildings, historical data of the same room or a comparable room in the same building, consumption simulation results, wherein reference data is obtained taking into account at least part of the building characteristics data set and/or the room characteristics data set, and optionally at least part of the measurement data set, and
an actual energy consumption associated with the room, wherein the actual energy consumption is calculated based at least in part on the measurement data set;
predicting (S14) energy savings associated with each of the energy preservation measures;
outputting (S15), via an application interface, at least some of the potential energy preservation measures and associated energy savings to a user; and
receiving (S16), via the application interface, a user selection of selected energy preservation measures to be implemented.

2. The method of claim 1, comprising determining (S17a) and outputting (S17b), for the selected energy preservation measures, actual energy saving after implementation of the respective selected energy preservation measure.

3. The method of any of the preceding claims, comprising outputting (S15a) together with the potential energy preservation measures and associated energy savings, an indication of a reason and/or criteria and/or a data source that underlies the determining of the respective energy preservation measure.

4. The method of any of the preceding claims, comprising determining (S18) an updated plurality of potential energy preservation measures associated with at least one of the one or more rooms, predicting (S19) energy savings associated with each of the updated energy preservation measures, outputting (S20) at least some of the updated potential energy preservation measures and associated energy savings to the user, and receiving (S21) a user selection of selected updated energy preservation measures to be implemented, in particular further comprising determining and outputting, for the selected updated energy preservation measures, actual energy saving after implementation of the respective selected updated energy preservation measure.

5. The method of any of claim 4, wherein the determining of the updated plurality of potential energy preservation measures is prompted by a user input and/or is triggered automatically, for example at predetermined intervals or whenever the user starts the application.

6. The method of any of the preceding claims, wherein predicting energy savings associated with each of the energy preservation measures comprises using historic data of the same room or other rooms to predict the energy savings of the respective energy preservation measure, particularly using said historic data for training a machine learning model to predict the energy savings.

7. The method of any of the preceding claims, comprising determining which of the potential energy preservation measures are output to the user based on the difference between expected energy consumption and actual energy consumption, particularly selecting potential energy preservation measures for which the difference exceeds a predetermined threshold and/or is among a predetermined number N of potential energy preservation measures associated with the highest difference.

8. The method of any of the preceding claims,
wherein the determining of potential energy preservation measures based on the difference between expected energy consumption and actual energy consumption comprises selecting a reference room by determining a room having, among a plurality of candidate reference rooms for which reference data is available, the highest similarity between the room and the reference room, wherein the similarity between the room and the reference room is determined based on at least part of the building characteristics data set and/or at least part of the room characteristics data set, and optionally at least part of the measurement data set, and
using the reference data associated with the selected reference room for determining the expected energy consumption.

9. The method of claim 8, wherein the similarity is determined by generating, for the room and the selected reference room, a respective vector representation representative of the room characteristics and optionally of the building characteristics and/or the measurement data, and
calculating a distance between the vector representative of the room and the vector representative of the respective reference room, the similarity being proportional to the distance.

10. The method of any of the preceding claims, wherein the determining of potential energy preservation measures based on the difference between expected energy consumption and actual energy consumption comprises determining whether the difference exceeds a threshold, particularly a threshold that indicates an anomaly in the actual energy consumption.

11. The method of any of the preceding claims, wherein the method comprises determining and outputting, together with the potential energy preservation measures, an indicator of a type or level of effort required for implementing the respective measure, such as whether implementing the measure requires adjustment of operation settings, modifying operation control programs, rearrangement or re-configuration of components in a room and/or construction measures.

12. The method of any of the preceding claims, comprising obtaining (S22) pricing data comprising one or more energy prices associated with energy supplied to the building and calculating (S23) and outputting (S24) expected cost savings associated with the potential energy preservation measures based on the energy prices and the expected energy savings and optionally determining (S25) and outputting (S26) actual cost savings associated with the selected energy preservation measures after implementation.

13. A system (1) comprising a data processing system (2) configured to carry out the method of any of the preceding claims.

14. A computer-program product comprising instructions which, when the program is executed by a computer, cause the computer to carry out the method of any of claims 1 to 12.

15. A computer-readable medium comprising instructions which, when the program is executed by a computer, cause the computer to carry out the method of any of claims 1 to 12.
